# EUROPÄISCHE PATENTSCHRIFT

(11) **EP 1 050 822 B1**
(45) Veröffentlichungstag und Bekanntmachung des Hinweises auf die Patenterteilung: **15.12.2004**
(21) Anmeldenummer: 00109637.9
(22) Anmeldetag: 05.05.2000
(51) Int. Cl.: G06F 13/16, G06F 11/00, G11C 8/16

(54) **Verfahren für einen Zugriff auf eine Speichereinrichtung**
Method for accessing a memory device
Méthode d'accès à un dispositif de mémoire

(30) Priorität: 06.05.1999 DE 19920992
(43) Veröffentlichungstag der Anmeldung: 08.11.2000
(73) Patentinhaber: SIEMENS AKTIENGESELLSCHAFT, 80333 München (DE)
(72) Erfinder: Gericke, Harald, 46119 Oberhausen (DE); Hoffmann, Christian, 58454 Witten (DE); Schicklinski, Peter, 81477 München (DE)

(56) Entgegenhaltungen:
- EP-A- 0 439 189
- DATABASE WPI Section EI, Week 199622 Derwent Publications Ltd., London, GB; Class T01, AN 1996-218743 XP002221103 & JP 08 083201 A (NISSAN MOTOR CO LTD), 26. März 1996 (1996-03-26)

## Beschreibung

Die Erfindung betrifft ein Verfahren für einen Lese- bzw. Schreibzugriff auf eine Speichereinrichtung gemäß dem Oberbegriff des Patentanspruchs 1 bzw. 2.

Aus der Produktschrift der Fa. Siemens "ISDN im Büro - HICOM", Sonderausgabe telcom report und Siemens-Magazin COM, 1985, ISBN 3-8009-3849-9, insbesondere der Seiten 58 bis 66, ist eine modular aufgebaute private Kommunikationsanlage bekannt. Die Kommunikationsanlage weist eine Vielzahl von, einem Anschluß von Teilnehmerendgeräten an die Kommunikationsanlage dienende Teilnehmeranschlußbaugruppen auf, wobei eine vorgegebene Anzahl von Teilnehmeranschlußbaugruppen jeweils in einer Anschlußeinheit zusammengefaßt sind. Hierbei ist den Anschlußeinheiten jeweils eine anschlußeinheitenindividuelle Steuerungseinrichtung zugeordnet.

Zur Speicherung von Daten auf den jeweiligen Teilnehmeranschlußbaugruppen weisen diese jeweils eine Speichereinrichtung auf, die in der Regel als sogenannter "Dual Ported RAM (Random Access Memory)" ausgebildet ist, d.h. die Speichereinrichtung weist zwei voneinander unabhängige Anschlüsse für Lese- bzw. Schreibzugriffe auf die Speichereinrichtung auf. Über die beiden Anschlüsse des "Dual Ported RAMs" sind somit gleichzeitige Zugriffe auf die Speichereinrichtung ausgehend von einem auf der Baugruppe angeordneten Prozessor, als auch von einem der Steuerungseinrichtung der jeweiligen Anschlußeinheit zugeordneten Prozessor möglich.

Aus dem Datenblatt "CMOS DUAL-PORT RAM", der Firma Integrated Device Technology Inc., November 1993, ist beispielsweise ein 'Dual Ported RAM' bekannt, das bei einem gleichzeitigen Zugriff auf dieselbe Speicherzelle dieser Speichereinrichtung für einen gesicherten Zugriff auf die Speicherzelle, d.h. für ein korrektes Auslesen einer Information aus der Speicherzelle bzw. ein korrektes Einspeichern einer Information in die Speicherzelle, die beiden gleichzeitigen Zugriffe in zwei sequentielle Zugriffe aufspaltet. Hierzu weist die Speichereinrichtung eine Arbitrierungslogik auf, die bei zwei gleichzeitigen, ausgehend von den beiden Anschlüssen erfolgenden Zugriffen auf dieselbe Speicherzelle der Speichereinrichtung einen ersten Anschluß der Speichereinrichtung für einen Schreib- bzw. Lesezugriff auf die Speichereinrichtung freigibt und einen zweiten Anschluß durch das Setzen eines sogenannten BUSY-Signals für einen gleichzeitigen Zugriff sperrt. Nach Beendigung des, über den ersten Anschluß erfolgenden Zugriffs wird der zweite Anschluß durch das Zurücksetzen des BUSY-Signals für einen nachfolgenden Lese- bzw. Schreibzugriff freigegeben.

Derartige, eine Arbitrierungslogik aufweisende 'Dual Ported RAMs' sind jedoch in der Regel teuer und benötigen zudem eine zusätzliche Signalisierung auf der Baugruppe - z.B. das BUSY-Signal - um zwei gleichzeitige Zugriffe auf dieselbe Speicherzelle der Speichereinrichtung in zwei sequentielle Zugriffe aufspalten zu können.

Der vorliegenden Erfindung liegt die Aufgabe zugrunde, ein Verfahren anzugeben, durch welches ein gesichertes Auslesen bzw. Einschreiben von Daten aus bzw. in eine Speichereinrichtung, insbesondere ein 'Dual Ported RAM' auf einfache Weise sichergestellt werden kann.

Gelöst wird die Aufgabe ausgehend von den Merkmalen des Oberbegriffs des Patentanspruchs 1 bzw. 2 durch deren kennzeichnenden Merkmale.

Ein wesentlicher Vorteil des erfindungsgemäßen Verfahrens besteht nun darin, daß durch ein n-maliges Lesen der in einer Speicherzelle gespeicherten Information bzw. der in eine Speicherzelle eingeschriebenen Information und ein nachfolgendes Vergleichen der n ausgelesenen Informationen auf einfache Weise gewährleistet wird, daß die, im Rahmen eines Lesezugriffs aus der Speicherzelle gelesene Information bzw. die, im Rahmen eines Schreibzugriffs in die Speicherzelle eingeschriebene Information korrekt ausgelesen bzw. eingespeichert wurde. Somit können durch das erfindungsgemäße Verfahren 'Dual Ported RAMs' verwendet werden, die keine Arbitrierungslogik für ein Aufspalten zweier gleichzeitiger Zugriffe in zwei sequentielle Zugriffe auf dieselbe Speicherzelle aufweisen und somit kostengünstiger sind.

Vorteilhafte Weiterbildungen der Erfindung sind in den Unteransprüchen angegeben.

Ein Vorteil von in den Unteransprüchen definierten Ausgestaltungen der Erfindung besteht darin, daß durch eine Erhöhung der Anzahl n der Lesevorgänge nach einem, im Rahmen eines Schreib- bzw. Lesezugriffs aufgetretenen Fehlers, die Wahrscheinlichkeit für ein Erkennen einer fehlerhaften ausgelesenen bzw. eingespeicherten Information erhöht wird.

Ein weiterer Vorteil von in den Unteransprüchen definierten Ausgestaltungen der Erfindung besteht darin, daß durch ein zufälliges variieren der Zeitabstände zwischen den n Lesevorgänge die Wahrscheinlichkeit für einen gleichzeitigen Zugriff auf dieselbe Speicherzelle ausgehend von beiden Anschlüssen der Speichereinrichtung verringert wird, und somit die Wahrscheinlichkeit für ein korrektes Auslesen einer, in einer Speicherzelle gespeicherten bzw. in eine Speicherzelle eingeschriebenen Information erhöht wird.

Ein Ausführungsbeispiel der Erfindung wird im folgenden anhand der Zeichnung näher erläutert.

Dabei zeigen:
- Fig. 1:: ein Blockschaltbild zur schematischen Darstellung der am erfindungsgemäßen Verfahren beteiligten wesentlichen Funktionseinheiten;
- Fig. 2:: ein Ablaufdiagramm zur Veranschaulichung der im Rahmen eines Lesezugriffs ablaufenden wesentlichen Verfahrensschritte;
- Fig. 3:: ein Ablaufdiagramm zur Veranschaulichung der im Rahmen eines Schreibzugriffs ablaufenden wesentlichen Verfahrensschritte.

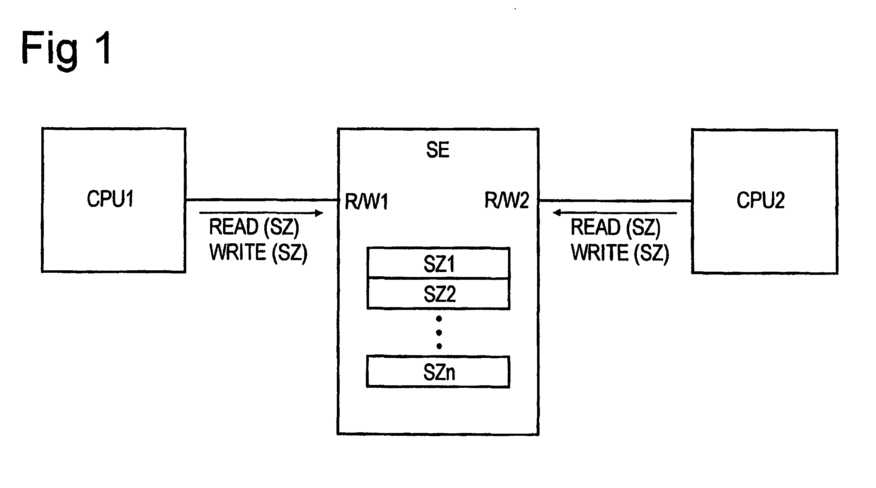

Fig. 1 zeigt eine schematische Darstellung einer, als 'Dual Ported RAM' ausgestalteten Speichereinrichtung SE die über einen ersten Schreib-Lese-Anschluß R/W1 mit einem ersten Prozessor CPU1 und über einen zweiten Schreib-Lese-Anschluß R/W2 mit einem zweiten Prozessor CPU2 verbunden ist. Des weiteren weist die Speichereinrichtung SE mehrere Speicherzellen SZ1,...,SZn zur Speicherung von, z.B. jeweils 8-Bit langen Datenblöcken auf.

Durch eine Übermittlung einer entsprechenden, eine Speicherzelle SZ1,...,SZn identifizierenden Lese-Anforderungsmeldung READ(SZ) von einem der Prozessoren CPU1, CPU2 an die Speichereinrichtung SE werden die, in der adressierten Speicherzelle SZ1,..., SZn gespeicherte Information ausgelesen und über den entsprechenden Schreib-Lese-Anschluß R/W1, R/W2 an den, die Lese-Anforderungsmeldung READ(SZ) sendenden Prozessor CPU1, CPU2 übermittelt. Analog werden durch eine Übermittlung einer entsprechenden, eine Speicherzelle SZ1,...,SZn identifizierenden Schreib-Anforderungsmeldung WRITE(SZ) von einem der Prozessoren CPU1, CPU2 an die Speichereinrichtung SE nachfolgend von diesem Prozessor CPU1, CPU2 über den entsprechenden Schreib-Lese-Anschluß R/W1, R/W2 übermittelte Daten in der adressierten Speicherzelle SZ1,...,SZn eingespeichert.

Bei einem gleichzeitigen Lese- bzw. Schreibzugriff des ersten und des zweiten Prozessors CPU1, CPU2 auf dieselbe Speicherzelle SZ1,...,SZn der Speichereinrichtung SE ist das Ergebnis undefiniert, d.h. die Korrektheit der aus der entsprechenden Speicherzelle SZ1,...,SZn ausgelesenen bzw. in die Speicherzelle SZ1,...,SZn eingespeicherten Information ist nicht gewährleistet. Hierbei ist jedoch nur ein gleichzeitiger Lesezugriff bzw. ein gleichzeitiger Lese- und Schreibzugriff durch die beiden Prozessoren CPU1, CPU2 auf dieselbe Speicherzelle SZ1,...,SZn der Speichereinrichtung SE möglich. Ein gleichzeitiger Schreibzugriff auf dieselbe Speicherzelle SZ1,...,SZn durch die beiden Prozessoren CPU1, CPU2 wird durch die Speichereinrichtung SE automatisch unterbunden.

Da die Prozessoren CPU1, CPU2 im Rahmen eines Lese- bzw. Schreibzugriffs auf eine Speicherzelle SZ1,...,SZn der Speichereinrichtung SE keine Information darüber erhalten, ob der jeweils andere Prozessor CPU1, CPU2 gleichzeitig auf dieselbe Speicherzelle SZ1,...,SZn der Speichereinrichtung SE zugreift, erfolgt beim erfindungsgemäßen Verfahren im Rahmen eines Lese- bzw. Schreibzugriffs auf die Speichereinrichtung SE ein mehrfacher Zugriff auf die Speicherzelle SZ1,...,SZn, so daß eine Überprüfung der aus einer Speicherzelle SZ1,..., SZn gelesenen bzw. der in die Speicherzelle SZ1,...,SZn eingespeicherten Information durch den jeweiligen den Zugriff initialisierenden Prozessor CPU1, CPU2 erfolgen kann.

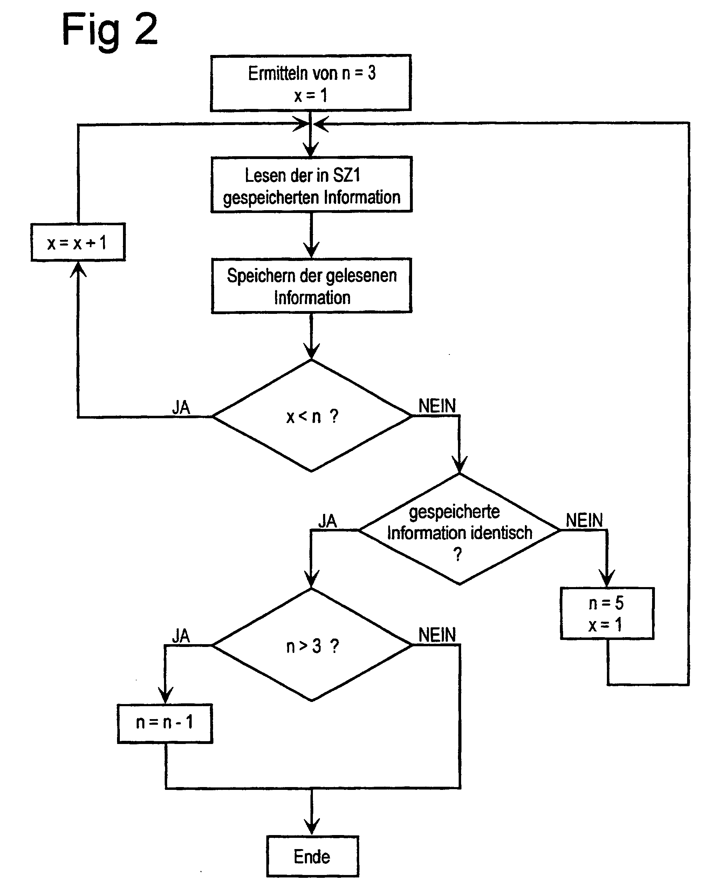

Fig. 2 zeigt ein Ablaufdiagramm zur Veranschaulichung der im Rahmen eines Lesezugriffs auf eine erste Speicherzelle SZ1 der Speichereinrichtung SE ablaufenden wesentlichen Verfahrensschritte. Für einen Lesezugriff auf die erste Speicherzelle SZ1 der Speichereinrichtung SE wird in einem ersten Schritt eine Anzahl n der, für eine Überprüfung der Korrektheit einer aus eine Speicherzelle SZ1,...,SZn gelesenen Information zu erfolgenden Lesezugriffe ermittelt. Beim vorliegenden Ausführungsbeispiel wird die Anzahl n der zu erfolgenden Lesezugriffe standardmäßig auf den Wert n = 3 gesetzt. Gleichzeitig wird eine verfahrensindividuelle Laufvariable x auf den Wert x = 1 gesetzt. In einem nächsten Schritt wird durch die Übermittlung einer entsprechenden Lese-Anforderungsmeldung READ(SZ1) die in der ersten Speicherzelle SZ1 gespeicherte Information ausgelesen und durch den, den Lesezugriff initialisierenden Prozessor CPU1, CPU2 gespeichert. Anschließend wird überprüft, ob die Laufvariable x kleiner als die Anzahl n der zu erfolgenden Lesezugriffe ist. Ist dies der Fall, wird die Laufvariable x um den Wert 1 erhöht und der beschriebene Lesezugriff wird solange wiederholt, bis die Laufvariable x gleich der Anzahl n der zu erfolgenden Lesezugriffe, also n = 3 ist.

Ist die Laufvariable x größer oder gleich der Anzahl n der zu erfolgenden Lesezugriffe werden in einem nächsten Schritt die n - in diesem Fall n = 3 - durch den Prozessor CPU1, CPU2 gespeicherten Informationen miteinander verglichen. Stimmen die gespeicherten Informationen nicht überein, wird die Anzahl n der zu erfolgenden Lesezugriffe auf den Wert 5 erhöht und die Laufvariable wird auf den Wert 1 zurückgesetzt. Um die Korrektheit der gelesenen Information gewährleisten zu können, kann die Anzahl n der zu erfolgenden Lesezugriffe von einen Benutzer auf einen beliebigen, von ihm als optimal ermittelten Wert gesetzt werden. Anschließend wird das beschriebene Verfahren wiederholt, bis die n - in diesem Fall n = 5 - gespeicherten Informationen übereinstimmen.

Stimmen die n gespeicherten Informationen überein, gilt die ausgelesene Information als korrekt und es wird abschließend überprüft, ob die Anzahl n der, für eine Überprüfung der Korrektheit der aus einer Speicherzelle SZ1,...,SZn gelesenen Information zu erfolgenden Lesezugriffe größer als n = 3 ist. Ist dies der Fall, wird die Anzahl n der zu erfolgenden Lesezugriffe um den Wert 1 dekrementiert.

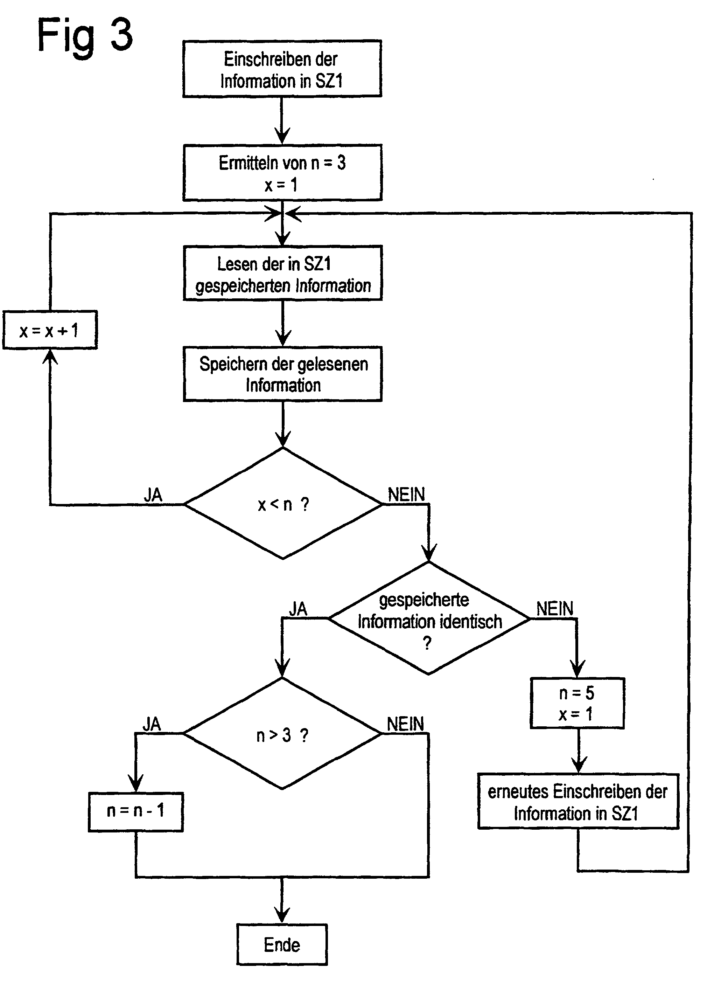

Fig. 3 zeigt ein Ablaufdiagramm zur Veranschaulichung der im Rahmen eines Schreibzugriffs auf die erste Speicherzelle SZ1 der Speichereinrichtung SE ablaufenden wesentlichen Verfahrensschritte. Nach einen Einspeichern einer einzuspeichernden Information in die erste Speicherzelle SZ1 der Speichereinrichtung SE wird in einem nächsten Schritt die Anzahl n der, für eine Überprüfung der Korrektheit einer in eine Speicherzelle SZ1,...,SZn eingespeicherten Information zu erfolgenden Lesezugriffe ermittelt. Beim vorliegenden Ausführungsbeispiel wird die Anzahl n der zu erfolgenden Lesezugriffe standardmäßig auf den Wert n = 3 gesetzt. Gleichzeitig wird die verfahrensindividuelle Laufvariable x auf den Wert x = 1 gesetzt. In einem nächsten Schritt wird durch die Übermittlung einer entsprechenden Lese-Anforderungsmeldung READ(SZ1) die in der ersten Speicherzelle SZ1 gespeicherte Information ausgelesen und durch den, den Lesezugriff initialisierenden Prozessor CPU1, CPU2 gespeichert. Anschließend wird überprüft, ob die Laufvariable x kleiner als die Anzahl n der zu erfolgenden Lesezugriffe ist. Ist dies der Fall, wird die Laufvariable x um den Wert 1 erhöht und der beschriebene Lesezugriff wird solange wiederholt, bis die Laufvariable x gleich der Anzahl n der zu erfolgenden Lesezugriffe, also x = 3 ist.

Ist die Laufvariable x größer oder gleich der Anzahl n der zu erfolgenden Lesezugriffe werden in einem nächsten Schritt die n - in diesem Fall n = 3 - durch den Prozessor CPU1, CPU2 gespeicherten Informationen jeweils mit der in die erste Speicherzelle SZ1 einzuschreibenden Information verglichen. Stimmen die gespeicherten Informationen nicht mit der in die erste Speicherzelle SZ1 einzuschreibenden Information überein, wird die Anzahl n der zu erfolgenden Lesezugriffe auf den Wert 5 erhöht und die Laufvariable wird auf den Wert 1 zurückgesetzt. Um die Korrektheit der gelesenen Information gewährleisten zu können, kann die Anzahl n der zu erfolgenden Lesezugriffe von einen Benutzer auf einen beliebigen, von ihm als optimal ermittelten Wert gesetzt werden. Anschließend wird die einzuschreibende Information erneut in die erste Speicherzelle SZ1 eingespeichert und das beschriebene Verfahren wird solange wiederholt, bis die n - in diesem Fall n = 5 - gespeicherten Informationen übereinstimmen.

Stimmen die n gespeicherten Informationen mit der in die erste Speicherzelle SZ1 einzuschreibenden Information überein, gilt die Information als korrekt eingespeichert und es wird abschließend überprüft, ob die Anzahl n der, für eine Überprüfung der Korrektheit einer, in einer Speicherzelle SZ1,...,SZn eingespeicherten Information zu erfolgenden Lesezugriffe größer als n = 3 ist. Ist dies der Fall, wird die Anzahl n der zu erfolgenden Lesezugriffe um den Wert 1 dekrementiert.

Beim erfindungsgemäßen Verfahren wird die Zeitspanne zwischen zwei, zur Überprüfung der Korrektheit einer, in eine Speicherzelle SZ1,...,SZn eingeschriebenen bzw. aus einer Speicherzelle SZ1,...,SZn ausgelesenen Information erfolgenden Lesevorgänge auf eine Speicherzelle SZ1,...,SZn der Speichereinheit SE variabel gehalten. Hierbei wird die Zeit zwischen zwei Lesevorgänge beispielsweise durch einen Zufallsgenerator innerhalb einer vorgegebenen Zeitspanne zufällig bestimmt. Dadurch wird gewährleistet, daß in Fällen, in denen durch die beiden Prozessoren CPU1, CPU2 ein gleichzeitiger Zugriff auf eine Speicherzelle SZ1,...,SZn der Speichereinrichtung SE erfolgt, ein zweiter, der Überprüfung der Korrektheit dienender Lesezugriff nicht erneut zur gleichen Zeit erfolgt und somit eine unbestimmte Information ausgelesen wird.

## Patentansprüche

1. Verfahren für einen Lesezugriff auf eine Speichereinrichtung (SE), wobei eine erste Zugriffseinrichtung (CPU1) über einen ersten Anschluß (R/W1) der Speichereinrichtung (SE) und eine zweite Zugriffseinrichtung (CPU2) über einen zweiten Anschluß (R/W2) der Speichereinrichtung (SE) mit der Speichereinrichtung (SE) verbunden sind,
**dadurch gekennzeichnet,**
**daß** bei dem Lesezugriff auf eine Speicherzelle (SZ1,...,SZn) der Speichereinrichtung (SE) durch die erste und/oder die zweite Zugriffseinrichtung (CPU1, CPU2) eine, in der Speicherzelle (SZ1,...,SZn) gespeicherte Information zeitlich nacheinander n-mal ausgelesen und anschließend verglichen wird, und daß
- in Fällen, in denen die n ermittelten Informationen identisch sind, die ausgelesene Information als korrekt ausgelesen gilt,
- in Fällen, in denen die n ermittelten Informationen nicht identisch sind, die in der Speicherzelle (SZ1,...,SZn) gespeicherte Information erneut zeitlich nacheinander n-mal ausgelesen und anschließend verglichen wird.

2. Verfahren für einen Schreibzugriff auf eine Speichereinrichtung (SE), wobei eine erste Zugriffseinrichtung (CPU1) über einen ersten Anschluß (R/W1) der Speichereinrichtung (SE) und eine zweite Zugriffseinrichtung (CPU2) über einen zweiten Anschluß (R/W2) der Speichereinrichtung (SE) mit der Speichereinrichtung (SE) verbunden sind,
**dadurch gekennzeichnet,**
**daß** bei dem Schreibzugriff auf eine Speicherzelle (SZ1,..., SZn) der Speichereinrichtung (SE) durch die erste und/oder die zweite Zugriffseinrichtung (CPU1, CPU2) eine, im Rahmen des Schreibzugriffs in der Speicherzelle (SZ1,...,SZn) gespeicherte Information zeitlich nacheinander n-mal ausgelesen und diese Informationen anschließend mit der in die Speicherzelle (SZ1,...,SZn) einzuspeichernden Information verglichen wird, und daß
- in Fällen, in denen die n ermittelten Informationen jeweils mit der in die Speicherzelle (SZ1,...,SZn) einzuschreibenden Information identisch sind, die in der Speicherzelle (SZ1,...,SZn) gespeicherte Information als korrekt eingeschrieben gilt,
- in Fällen, in denen die n ermittelten Informationen nicht mit der in die Speicherzelle (SZ1,...,SZn) einzuschreibenden Information identisch sind, die Information erneut in die Speicherzelle (SZ1,...,SZn) eingeschrieben wird und die gespeicherte Information erneut zeitlich nacheinander n-mal ausgelesen und diese Informationen anschließend mit der in die Speicherzelle (SZ1,...,SZn) einzuspeichernden Information verglichen wird.

3. Verfahren nach Anspruch 1 oder 2,
**dadurch gekennzeichnet,**
**daß** in Fällen, in denen die n ermittelten Informationen nicht identisch sind, die Anzahl der Lesezugriffe n auf einen vorgebbaren Wert erhöht wird, und
**daß** nachfolgend infolge eines korrekten Lese- bzw. Schreibzugriffs auf eine Speicherzelle (SZ1,...,SZn) die Anzahl n der Lesevorgänge um den Wert 1 solange dekrementiert wird, bis die ursprünglich Anzahl n der Lesevorgänge erreicht ist.

4. Verfahren nach einem der vorhergehenden Ansprüche,
**dadurch gekennzeichnet,**
**daß** die n Lesevorgänge in variablen Zeitabständen voneinander erfolgen.

## Claims

1. Method for a read access to a memory device (SE), in which a first access device (CPU1) is connected via a first port (R/W1) of the memory device (SE) and a second access device (CPU2) is connected via a second port (R/W2) of the memory device (SE) to the memory device (SE),
**characterized in that**,
for the read access to a memory cell (SZ1,...,SZn) of the memory device (SE) by the first and/or the second access device (CPU1, CPU2) an item of information stored, in the memory cell (SZ1,...,SZn) is read out consecutively n times and subsequently compared, and **in that**
- in cases in which the n items of information determined are identical, the information read out is deemed to be correct,
- in cases in which the n items of information determined are not identical, the information stored in the memory cell (SZ1,...,SZn) is again read out consecutively n times and subsequently compared.

2. Method for a write access to a memory device (SE), in which a first access device (CPU1) is connected via a first port (R/W1) of the memory device (SE) and a second access device (CPU1) is connected via a second port (R/W1) of the memory device (SE) to the memory device (SE),
**characterized in that**,
for a write access to a memory cell (SZ1,...,SZn) of the memory device (SE) by the first and/or the second access device (CPU1, CPU2) information stored as part of the write access in the memory cell (SZ1,...,SZn) is read out consecutively n times and this information is subsequently compared with the information to be stored in the memory cell (SZ1,...,SZn), and that
- in cases in which the n items of information determined are identical with the information to be written into the memory cell (SZ1,...,SZn) in each case. the information stored in the memory cell (SZ1,...,SZn) is deemed to have been written in correctly,
- in cases in which the n items of information determined are not identical with the information to be written into the memory cell (SZ1,...,SZn), the information is written into the memory cell again (SZ1,...,SZn) and the stored information is again read out consecutively n times and this information is subsequently compared with the information to be stored in the memory cell (SZ1,...,SZn).

3. Method in accordance with Claim 1 or 2,
**characterized in that**,
in cases in which the n items of information determined are not identical, the number of read accesses n is increased to a specifiable value, and
that subsequently as a result of a correct read or write access to a memory cell (SZ1,...,SZn) the number n of the read processes is decremented by 1 until the original number n of the read processes is reached.

4. Method according to one of the previous claims
**characterized in that**,
the n read processes occur at variable intervals from each other.

## Revendications

1. Méthode d'accès de lecture à un dispositif de mémoire (SE), un premier dispositif d'accès (CPU1) et un deuxième dispositif d'accès (CPU2) étant reliés au dispositif de mémoire (SE), l'un par l'intermédiaire d'un premier raccordement (R/W1) du dispositif de mémoire (SE) et l'autre par l'intermédiaire d'un deuxième raccordement (R/W2) du dispositif de mémoire (SE), **caractérisé en ce que**, lors de l'accès de lecture à une cellule de mémoire (SZ1, ..., SZn) du dispositif de mémoire (SE) par le premier et/ou le deuxième dispositif d'accès (CPU1, CPU2), une information mise en mémoire dans la cellule de mémoire (SZ1, ..., SZn) est extraite n fois successivement dans le temps et est ensuite comparée et **en ce que**
- dans les cas dans lesquels les n informations déterminées sont identiques l'information extraite est réputée être correctement extraite;
- dans les cas dans lesquels les n informations déterminées ne sont pas identiques , l'information mise en mémoire dans la cellule de mémoire (SZ1, ..., SZn) est de nouveau extraite n fois successivement dans le temps et est ensuite comparée.

2. Méthode d'accès d'écriture à un dispositif de mémoire (SE), un premier dispositif d'accès (CPU1) et un deuxième dispositif d'accès (CPU2) étant reliés au dispositif de mémoire (SE), l'un par l'intermédiaire d'un premier raccordement (R/W1) du dispositif de mémoire (SE) et l'autre par l'intermédiaire d'un deuxième raccordement (R/W2) du dispositif de mémoire (SE),
**caractérisée en ce que**,
lors de l'accès d'écriture à une cellule de mémoire (SZ1, ..., SZn) du dispositif de mémoire (SE) par le premier et/ou le deuxième dispositif d'accès (CPU1, CPU2), une information mise en mémoire dans la cellule de mémoire (SZ1, ..., SZn) dans le cadre de l'accès d'écriture est extraite n fois successivement dans le temps et cette information est ensuite comparée avec l'information à mettre en mémoire dans la cellule de mémoire (SZ1, ..., SZn) et **en ce que**
- dans les cas dans lesquels les n informations déterminées sont identiques respectivement avec l'information à inscrire dans la cellule de mémoire (SZ1, ..., SZn), l'information mise en mémoire dans la cellule de mémoire (SZ1, ..., SZn) est réputée être correctement inscrite;
- dans les cas dans lesquels les n informations déterminées ne sont pas identiques avec l'information à inscrire dans la cellule de mémoire (SZ1, ..., SZn), l'information est de nouveau inscrite dans la cellule de mémoire (SZ1, ..., SZn) et l'information mise en mémoire est de nouveau extraite n fois successivement dans le temps et ces informations sont ensuite comparées avec l'information à mettre en mémoire dans la cellule de mémoire (SZ1, ..., SZn).

3. Méthode selon la revendication 1 ou 2,
**caractérisée en ce que**
dans les cas, dans lesquels les n informations déterminées ne sont pas identiques , le nombre des accès de lecture n à une valeur prédéterminable est augmenté et **en ce qu'**ensuite, à la suite d'un accès de lecture resp. d'écriture correct à une cellule de mémoire (SZ1, ..., SZn), le nombre n des opérations de lecture est décrémenté de la valeur 1 jusqu'à ce que le nombre initial n des opérations de lecture soit atteint.

4. Méthode selon l'une des revendications précédentes,
**caractérisée en ce que**
les n opérations de lecture se font à des intervalles de temps variables les séparant.
